Europäisches Patentamt

European Patent Office

Office européen des brevets

(19)

(11) Veröffentlichungsnummer: **0 089 397**
**B1**

# (12) EUROPÄISCHE PATENTSCHRIFT

(45) Veröffentlichungstag der Patentschrift:
04.12.85

(51) Int. Cl.⁴: **G 11 C 29/00**

(21) Anmeldenummer: **82102447.8**

(22) Anmeldetag: **24.03.82**

(54) **Integrierte Speichermatrix mit nichtflüchtigen, umprogrammierbaren Speicherzellen.**

(43) Veröffentlichungstag der Anmeldung:
28.09.83 Patentblatt 83/39

(45) Bekanntmachung des Hinweises auf die Patenterteilung:
04.12.85 Patentblatt 85/49

(84) Benannte Vertragsstaaten:
DE FR GB IT NL

(56) Entgegenhaltungen:
US - A - 4 127 901
US - A - 4 181 980
US - A - 4 223 394

ELECTRONICS INTERNATIONAL, Band 53, Nr. 17, Juli 1980, Seiten 89-92, New York, USA E.K. SHELTON: "Low-power EE-PROM can be programmed fast"

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Giebel, Burkhard, Dipl.-Ing., Asenweg 15, D-8000 München 83 (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

**Beschreibung**

In der Literatur sind programmierbare, nichtflüchtige Speicherzellen unter verschiedenen, zumeist aus englischsprachigen Begriffen abgeleiteten Abkürzungen bekannt. Es handelt sich dabei stets um Speicherzellen mit Isolierschicht-Feldefekttransistor-Strukturen, welche je ein Speichermedium aufweisen. In der folgenden Beschreibung wird unter »Schreiben« ein Vorgang verstanden, bei dem durch Anlegen von Spannungen an die Elektroden der Zellen Ladungen vom Vorzeichen der Source- und Drain-Zone in ein über dem Kanalbereich liegendes Speichermedium gelangen, und unter »Löschen« ein solcher Vorgang verstanden, bei dem diese Ladungen ebenfalls durch Anlegen von Spannungen oder auch durch eine Ultraviolettstrahlung aus dem Speichermedium wieder entfernt werden. Einen Überblick über die betroffenen Speicherzellen gibt der Aufsatz »Nonvolatile Semiconductor Memory Devices« auf den Seiten 1039 bis 1040 in der Zeitschrift »Proceedings of the IEEE«, Bd. 64, Nr. 7 (Juli 1976).

Die Erfindung bezieht sich auf eine integrierte Speichermatrix, in der m mal n Speicherzellen in m Spalten und n Zeilen angeordnet sind. Die Speicherzellen können allein aus Speichertransistoren bestehen, sie können aber auch, wie es aus der Zeitschrift »Elektronics« vom 28. Februar 1980, Seiten 113 bis 117, bekannt ist, zusätzlich einen Auswahltransistor im Strompfad des Speichertransistors aufweisen, dessen Gate an einer Auswahlleitung liegt.

Bei der Überwachung der Fertigung solcher Speichermatrizen, wie auch bei der Endmessung, tritt das Problem auf, die Speichermatrizen nach den Schwellenwerten der Zellen klassifizieren zu können, wozu im Normalfall nacheinander sämtliche Zellen angewählt und geprüft werden müssen.

Aus der US-PS 4 127 901 ist eine integrierte Speichermatrix mit nichtflüchtigen, umprogrammierbaren, in Spalten und Zeilen angeordneten Speicherzellen bekannt, die jeweils zwei MNOS-Speichertransistoren aufweisen, von deren Source-Drain-Strömen beim Anwählen der Adresse der Speicherzelle Spannungssignale ableitbar sind.

In einer ersten Betriebsart (memory retention interrogation mode) werden die Schwellwertspannungen von MNOS-Speichertransistoren ausgemessen, indem deren Ausgangsspannungen mit einer Referenzspannung $V_R$ verglichen werden, wobei die Referenzspannungsquelle und die Vergleichsschaltung auf dem Halbleiterkörper der Speicher mitintegriert sind. Dies ist die für die Anmeldung wichtige Betriebsart.

In einer zweiten Betriebsart (read interrogation mode) wird die Information ausgelesen, indem die Ausgangsspannungen zweier mit entgegengesetzten logischen Signalen beaufschlagte MNOS-Speichertransistoren verglichen werden. Diese Betriebsart ist vergleichbar mit der in bezug auf die DE-A-2 620 746 erwähnten Ausleseart: Die Ausgangsspannung der Speicherzelle wird mit der einer mitintegrierten und mit fester Spannung beaufschlagten Referenzzelle verglichen.

Die Erfindung betrifft eine integrierte Speichermatrix gemäß dem Oberbegriff des Anspruchs 1, wie sie aus der obenerwähnten US-PS 4 127 901 bekannt ist.

Aufgabe der Erfindung ist die Lösung des erwähnten Problems der Klassifikation mit wesentlich geringerem Schaltungsaufwand und damit auch geringeren Zeitaufwand als es nach dem bekannten Stand der Technik möglich ist.

Die Erfindung beruht auf dem Gedanken, zu diesem Zweck den Speichertransistor einer einzelnen gleichartigen Referenzzelle zu verwenden, welche mit in den Halbleiterkörper der integrierten Speichermatrix integriert ist, d. h. eine Referenzzelle gleichen Aufbaus, welche gleichzeitig mit der Speicherzelle der Matrix in ihrem Halbleiterkörper hergestellt wird.

Die obengenannte Aufgabe wird erfindungsgemäß durch die im kennzeichnenden Teil des Anspruchs 1 genannte Ausbildung gelöst.

Die integrierte Speichermatrix nach der Erfindung unterscheidet sich von der bekannten nach der US-PS 4 127 901 also in der Verwendung eines einzelnen nichtprogrammierbaren Referenz-Speichertransistors einer einzelnen Speicherzelle als Referenz-Spannungsquelle in Verbindung mit mindestens einer damit verbundenen stufenweise einstellbaren Spannungsquelle. Dies bedeutet nicht nur einen geringeren Schaltungsaufwand, sondern hat auch noch den Vorteil, daß ein Vergleichspannungsnormal vorgegeben ist, welches gleich dem Grenzwert der Schwellenspannung einer programmierten Speicherzelle gleicher Zellenart ist. Die Relativwerte der Schwellwertfenster werden, bezogen auf dieses Vergleichspannungsnormal, unmittelbar gewonnen.

Vorzugsweise sind die erste und die zweite Spannungsquelle aus Isolierschicht-Feldeffekttransistoren aufgebaute Spannungsteiler, welche im Halbleiterkörper der Speicherzelle mitintegriert sind. Die Spannungsteiler weisen je einen Basistransistor auf und eine Anzahl von parallelgeschalteten Lasttransistoren, die in ihren Breiten/Längenverhältnissen der Kanalzonen abgestuft sind. Die Lasttransistoren werden entsprechend dem gewählten Spannungswert leitend gesteuert.

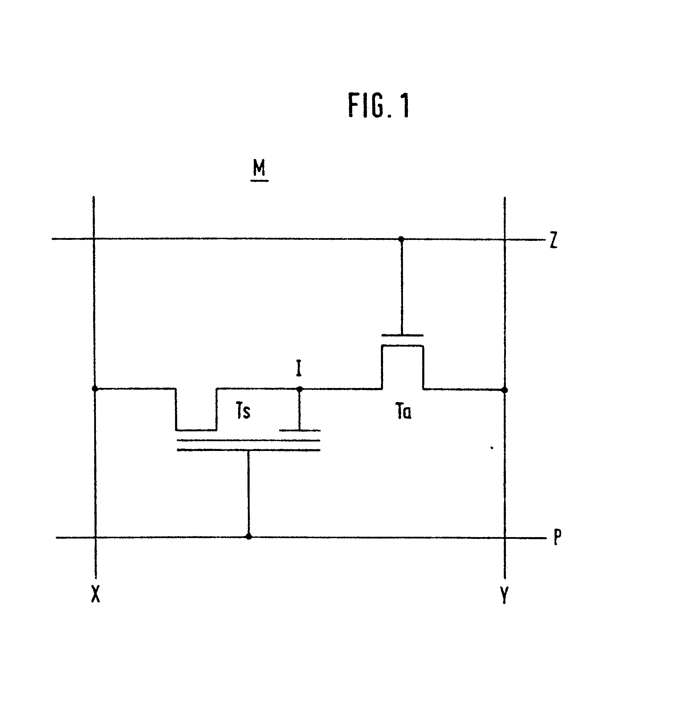

Die Erfindung wird im folgenden anhand der Figuren der Zeichnung an einem bevorzugten Ausführungsbeispiel erläutert, bei welchem die integrierte Speichermatrix umprogrammierbare Speicherzellen M11 ... Mm1, M1n ... Mmn enthält, die jeweils einen bezüglich eines Floating-Gates Fg in beiden Stromrichtungen wirksamen Tunnelinjektor I aufweisen, wie die Fig. 1 veranschaulicht. Eine integrierte Speichermatrix mit solchen Speicherzellen ist aus der bereits erwähnten Zeitschrift »Electronics« vom 28. Februar 1980, Seiten 113 bis 117, bekannt.

Bei der Speicherzelle gemäß der Fig. 1 ist der Tunnelinjektor I einerseits über die Source-Drain-Strecke eines Speichertransistors Ts mit einer ersten Bitleitung X und andererseits über die Source-Drain-Strecke eines Auswahltransistors Ta mit einer zweiten Bitleitung Y verbunden. Während das Gate des Speichertransistors Ts an einer Programmierleitung P liegt, ist das Gate des Auswahltransistors Ta mit einer Auswahlleitung Z verbunden, welche an einem der Ausgänge eines Zeilendekoders Dz liegt, der zur zeilenweisen Anwahl der Speicherzellen der Speichermatrix dient.

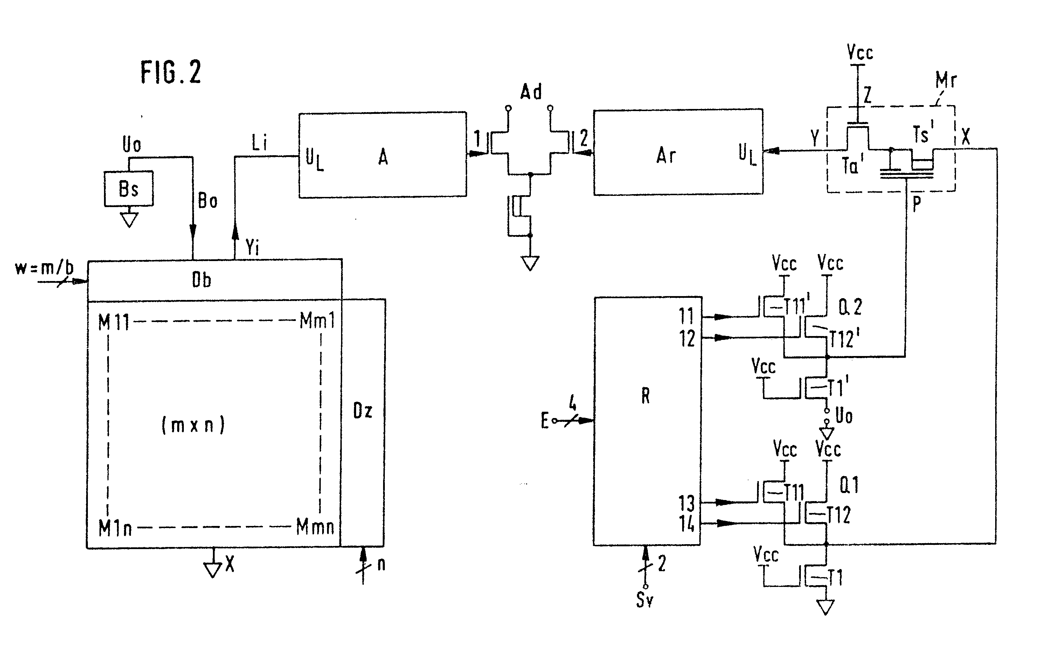

Außer dem Zeilendekoder Dz ist, wie das Blockschaltbild der Fig. 2 zeigt, in der Peripherieschaltung der Speichermatrix S der Blockdekoder Db vorgesehen, mit dessen Hilfe einer von w = m/b Blöcken von n in Spaltenrichtung angeordneten Speichergruppen angewählt werden kann. Die ersten Bitleitungen X liegen beim Lesebetrieb am Schaltungsnullpunkt, wie aus der Fig. 2 ersichtlich ist.

Zum Anwählen der i-ten Speicherzelle wird deren Zeile mittels des Zeilendekoders Dz und deren Block mittels des Blockdekoders Db angewählt. Jeder der b Speicherzellen kann somit über eine der b Datenleitungen Li erreicht werden, wovon der Übersichtlichkeit wegen aber lediglich die i-te in Betracht gezogen wird. Beim Anwählen der Adresse einer i-ten Speicherzelle wird an dieser die Lesespannung $U_L$ wirksam, so daß durch deren Speichertransistor ein Source-Drain-Strom entsprechend des jeweiligen Informationsgehalts fließt. Dementsprechend wird mittels eines Leseverstärkers aus diesem Strom ein erstes Spannungssignal abgeleitet, welches an den ersten Eingang 1 einer in Form eines Differenzverstärkers ausgebildeten Vergleichsschaltung Ad angelegt wird. Als Vergleichsschaltung kann auch ein bistabiler Multivibrator verwendet werden, wie es aus der genannten DE-OS 2 620 749 bekannt ist.

Der zweite Eingang 2 der Vergleichsschaltung Ad liegt am Ausgang eines dem Leseverstärker A gleichenden Referenz-Leseverstärkers Ar. Dessen Eingang liefert die Lesespannung $U_L$ von gleicher Größe wie diejenige des Eingangs des Leseverstärkers A. Im Eingangskreis des Referenz-Leseverstärkers Ar liegt entsprechend der Erfindung die Source-Drain-Strecke des Speichertransistors Ts' einer nicht programmierten Referenzzelle Mr, die mit den Speicherzellen der Speichermatrix S identisch ist und gleichzeitig mit diesen hergestellt wird.

Durch die Verwendung der Referenzzelle Mr ist ein Vergleichsspannungsnormal vorgegeben, welches gleich dem Grenzwert der Schwellenspannung einer programmierten Speicherzelle gleicher Zellenart ist, dem sich die Schwellenspannung einer sich selbst entladenden, programmierten Speicherzelle zeitlich asymptotisch annähert.

Wird beispielsweise eine N-Kanal-Speicherzelle mit einem potentialmäßig schwebenden Speichergate durch Entzug der Elektronen vom Speichergate auf die logische »Eins« gesetzt, so wird die Schwellenspannung gegenüber der der Referenzzelle Mr um einen bestimmten Betrag abgesenkt, der als Qualitätskriterium herangezogen werden kann. Maximalwerte des Schwellenspannungsfensters werden aber relativ selten erreicht und sind für die praktische Verwendung auch zumeist nicht erforderlich. Zum Testbetrieb muß aber zunächst als Bewertungsgrenze eine Schwellenspannung zwischen der der geschriebenen Zelle und der als Referenzzelle Mr dienenden »jungfräulichen« Zelle vorgegeben werden. Dies wird durch eine besondere Beschaltung der Referenzzelle mit anderen Potentialen als den die Speicherzellen M erreichenden Potentialen erreicht, wobei eine Schwellenspannung simuliert wird, die als Bewertungsgrenze ausgenutzt wird. Die Referenzzelle Mr wird zu diesem Zwecke mit anderen Potentialen als den die Speicherzellen erreichenden Potentialen versorgt. Es lassen sich so Wirkungen erzielen, die Veränderungen der die Speicherzellen ansteuernden Potentiale gleichkommen.

Zu diesem Zwecke wird im Eingangsstromkreis des Referenz-Leseverstärkers Ar, in dem die Sourc-Drain-Strecke des Speichertransistors Ts' der Referenzzelle Mr liegt, eine erste Spannungsquelle Q1 angeordnet, deren Spannung stufenweise einstellbar ist. Ferner wird die Gateelektrode des Speichertransistors Ts' der Referenzzelle Mr mit dem einen Anschluß einer stufenweise einstellbaren zweiten Spannungsquelle Q2 verbunden. Wird beispielsweise an den P-Anschluß einer N-Kanal-Referenzzelle ein positiveres Potential angelegt, so wird eine Absenkung der Bewertungsgrenze durch die scheinbare Verschiebung der Schwellspannung $U_d$ auf negativere Werte erreicht und umgekehrt bei Anlegen eines negativeren Signals. Ferner wird durch Anlegen eines positiveren Potentials an den X-Anschluß der Referenzzelle eine Erhöhung der Schwellspannung $U_d$ simuliert und damit die Bewertungsgrenze angehoben. Ein Absenken der Bewertungsgrenze ergibt sich durch Anlegen eines negativeren Potentials an den X-Anschluß. Die beiden Spannungsquellen Y1 und Y2, deren Ausgangsspannung stufenweise einstellbar ist, werden ebenfalls mit in den Halbleiterkörper der Speichermatrix integriert.

Vorzugsweise werden diese beiden Spannungsteiler Y1 und Y2, wie die Fig. 2 zeigt, in Form von Spannungsteilern aus Isolierschicht-Feldeffekttransistoren aufgebaut. Jeder der Spannungsteiler enthält einen Basistransistor T1 bzw. T1', dessen Sourceelektrode auf Masse und dessen Gateelektrode an einem festen Potential, beispielsweise an der Versorgungsspannung Vcc, liegen. Mit der Drainzone jedes der Basistransistoren T1 bzw. T1' sind die Sourceelektroden einer Mehrzahl von Lasttransistoren T11, T12; T11', T12' verbunden, welche in ihren Breiten/Längenverhältnissen W/L der Kanalzonen abgestuft sind. Da am Steuergate des Speichertransistors einer angesteuerten Speicherzelle M der Speichermatrix das Blocksignal Uo der Blocksignalquelle Bs über die Blockleitung Bo anliegt, liegt die Sourceelektrode des Basistransistors T1′ der zweiten Spannungsquelle Y2 ebenfalls auf dem Potential Uo als Bezugsspannung.

Bei Verwendung von jeweils zwei Lasttransistoren T11 und T12 bzw. T11′ und T12′ in den beiden Spannungsquellen Q1 bzw. Q2 ergibt sich die Möglichkeit der Simulation von 16 Schwellwerten des Speichertransistors Ts′ in der Referenzzelle Mr. Zur Wahl eines Schwellwertes der Referenzzelle Mr ist ein Register R mit vier Ausgängen 11, 12, 13, 14 vorgesehen, welche gemäß Fig. 2 mit je einem Gate der einzelnen Lasttransistoren T11, T12, T11′, T12′ verbunden sind. Das Register weist ferner entsprechend den erwähnten 16 Möglichkeiten vier Registereingänge E auf, über die je ein einem Ausgang zugeordnetes statisches Register einstellbar ist. Nach Wahl des simulierten Schwellwertes durch Eingabe eines entsprechenden Bytes über den Registereingang E wird das Register durch Anlegen eines Verriegelungssignals an den Verriegelungseingang Sv verriegelt.

Wird dem gelöschten Zustand der Speicherzellen die logische »Eins« zugeordnet und unter »Löschen« die negativere Aufladung des Speichergates mit einem N-Kanal-Speichertransistor verstanden, dann kann durch einen simulierten relativ großen Schwellwert des Speichertransistors der Referenzzelle Mr eine Bewertungsgrenze für die eine »Qualität« der logischen »Eins« und durch eine Simulation eines relativ kleinen Schwellwertes des Speichertransistors Ts′ der Referenzzelle Mr die andere »Qualität« für logischen »Null« vorgegeben werden. Werden nun entsprechend der Bitanzahl b der Speichergruppen b Differenzverstärker vorgesehen, an deren erste Eingänge je eine Datenleitung einer Speicherzelle der jeweils angewählten Speichergruppe angeschlossen ist und an deren zweite Eingänge ein Signal entsprechend dem »simulierten« Schwellwert der Referenzzelle anliegt, dann können in beliebiger Reihenfolge sämtliche Gruppen gruppenweise auf die Qualitäten der logischen »Eins« und auch der logischen »Null« überprüft werden, indem ein solches simulierte Schwellwertpaar mittels des Registers R vorgegeben wird, welches für die Qualität der integrierten Speichermatrix charakteristisch ist.

Wie aus der Fig. 2 und der vorstehenden Beschreibung ohne weiteres ersichtlich ist, ist der schaltungstechnische Aufwand in der integrierten Speichermatrix nach der Erfindung zur Realisierung eins Test-Lesebetriebes im Vergleich zur Wirkung gering und läßt sich so gestalten, daß die Adreß-Zugriffzeit nicht beeinflußt wird.

**Patentansprüche**

1. Integrierte Speichermatrix mit nichtflüchtigen, umprogrammierbaren, in Spalten und Zeilen angeordneten Speicherzellen, die jeweils einen Speichertransistor (Ts) aufweisen, von dessen Source-Drain-Strom beim Anwählen der Adresse der Speicherzelle (M) des Speichertransistors (Ts) ein erstes Signal abgeleitet wird, welches über einen Leseverstärker (A) an den ersten Eingang einer integrierten Vergleichsschaltung (Ad) angelegt wird, während vom Source-Drain-Strom eines Referenz-Speichertransistors (Ts′) von einem hinsichtlich des Speichertransistors (Ts) identischen Aufbau ein zweites Signal abgeleitet wird, welches über einen Referenz-Leseverstärker (Ar) an den zweiten Eingang der integrierten Vergleichsschaltung (Ad) angelegt wird,
wobei der Referenz-Leseverstärker (Ar), der Referenz-Speichertransistor (Ts′) und die stufenweise einstellbare Spannungsquelle im Halbleiterkörper der Speichermatrix (S) integriert sind, gekennzeichnet durch folgende Merkmale:

— der Referenz-Speichertransistor (Ts′) ist nicht programmierbar,
— in dem den Eingangsstromkreis des Referenz-Leseverstärkers (Ar) und die Source-Drain-Strecke des nichtprogrammierbaren Referenz-Speichertransistors (Ts′) enthaltenden Stromkreis liegt eine erste Spannungsquelle (Q1), deren Spannung stufenweise einstellbar ist,
— und/oder die Gateelektrode des Referenz-Speichertransistors (Ts′) ist mit dem einen Anschluß einer stufenweise einstellbaren zweiten Spannungsquelle (Q2) verbunden.

2. Integrierte Speichermatrix nach Anspruch 1, dadurch gekennzeichnet, daß mindestens eine der Spannungsquellen (Q1, Q2) ein aus Isolierschicht-Feldeffekttransistoren (T11, T1, T12; T11′, T1′, T12′) aufgebauter und im Halbleiterkörper der Speichermatrix integrierter Spannungsteiler ist, der je einen Basistransistor (T1, T1′) und eine Anzahl von in ihren Breiten/Längen-Verhältnissen (W/L) der Kanalzonen abgestuften Lasttransistoren (T11, T11′; T12, T12′) aufweist, deren Source-Drain-Strecken entsprechend dem gewählten Spannungswert leitend steuerbar sind.

3. Integrierte Speichermatrix nach Anspruch 2, dadurch gekennzeichnet, daß jede der Gateelektroden der Lasttransistoren (T11, T12; T11′, T12′) mit je einem Ausgang (11, 12, 13, 14) eines im Halbleiterkörper der Speichermatrix integrierten Registers (R) verbunden ist, welches über die äußeren Anschlüsse der integrierten Speichermatrix einstellbar und über mindestens einen zusätzlichen äußeren Anschluß (Sv) verriegelbar ist.

**Claims**

1. Integrated storage matrix comprising nonvolatile reprogrammable storage cells arranged in rows and columns, which are each provided with a storage transistor (Ts), from the source-drain current of which, when selecting the address of the storage cell (M) of the storage transistor (Ts), a first signal is derived which, via a read-write amplifier (A) is applied to the first input of an integrated comparator circuit (AD), while from the source-drain current of a reference storage transistor (Ts') which is identical compared to the storage transistor (Ts), a second signal is derived which, via a reference read-write amplifier (A₀), is applied to the second input of the integrated comparator circuit, with the reference read-write amplifier (A₅), the reference storage transistor (Ts') and the stepwisely adjustable voltage source being integrated into the semiconductor body of the storage matrix (S),

characterized by the following features:

— the reference storage transistor (Ts') is not programmable,
— in the circuit containing the input circuit of the reference read-write amplifier (A₅) and the source-drain line of the non-programmable reference storage transistor (Ts') a first voltage source (Q1) is disposed whose voltage is stepwisely adjustable,
— and/or the gate electrode of the reference storage transistor (Ts') is connected to the one terminal of a stepwisely adjustable second voltage source (Q2).

2. An integrated storage matrix as claimed in claim 1, characterized in that at least one of the voltage sources (Q1, Q2) is a voltage divider composed of insulated-gate fieldeffect transistors (T11, T1, T12; T11', T1', T12') and integrated into the semiconductor body of the storage matrix, with the voltage divider comprising one base transistor each (T1, T1') and a number of load transistors (T11, T11'; T12, T12') gradated in their width-to-length (W/L) ratios of the channel regions, and with the source-drain lines thereof capable of being switched to the conducting state in accordance with the chosen voltage value.

3. An integrated storage matrix as claimed in claim 2, characterized in that each of the gate electrodes of the load transistors (T11, T12; T11', T12') is connected to one output each (11, 12, 13, 14) of a register (R) integrated into the semiconductor body of the storage matrix, with this register (R) being adjustable via the outer terminals of the integrated storage matrix, and lockable via at least one additional outer terminal (Sv).

**Revendications**

1. Matrice de mémoire intégrée comprenant des cellules de mémoire non volatiles, reprogrammables, disposées en colonnes et en rangées, comportant chacune un transistor de mémoire (Ts), un premier signal pouvant être dérivé des courants de source et de drain desdits transistors de mémoire lors de la sélection de l'adresse de la cellule mémoire (M) du transistor de mémoire (Ts), ledit premier signal étant appliqué par l'intermédiaire d'un amplificateur de lecture (A) à la première entrée d'un circuit intégré de comparaison (Ad) tandis qu'à partir du courant de source et de drain d'un transistor de mémoire de référence (Ts') de conception identique au transistor de mémoire (Ts) est dérivé un second signal qui est appliqué par l'intermédiaire d'un amplificateur de lecture de référence (Ar) à la seconde entrée du circuit intégré de comparaison (Ad), l'amplificateur de lecture de référence (Ar), le transistor de mémoire (Ts') et la source de tension à réglage progressif étant intégrés dans l'élément semi-conducteur de la matrice de mémoire (S),

caractérisée en ce que:

— le transistor de mémoire de référence (Ts') n'est pas programmable,
— dans le circuit renfermant le circuit d'entrée de l'amplificateur de lecture de référence (Ar) et le trajet source-drain du transistor de mémoire de référence non programmable (Ts') est prévue une première source de tension (Q1) dont la tension est réglable progressivement,
— et/ou l'électrode de grille du transistor de mémoire de référence (Ts') est raccordée à l'une des bornes d'une seconde source de tension (Q2) à réglage progressif.

2. Matrice de mémoire intégrée conforme à la revendication 1, caractérisée en ce que au moins une des sources de tension (Q1, Q2) est un diviseur de tension conçu à partir de transistors à effet de champ à grille isolée (T11, T1, T12; T11', T1', T12') et intégré dans l'élément semi-conducteur de la matrice de mémoire, ledit diviseur de tension comportant un transistor de base (T1, T1') et plusieurs transistors de charge (T11, T11'; T12, T12') dont les rapports largeur/longueur (W/L) des zones de canal sont étagés et dont les trajets source-drain peuvent être commandés en fonction de la valeur de tension choisie.

3. Matrice de mémoire intégrée conforme à la revendication 2, caractérisée en ce que chacune des électrodes de grille des transistors de charge (T11, T12; T11', T12') est reliée à une sortie (11, 12, 13, 14) d'un registre (R) intégré dans l'élément semi-conducteur de la matrice de mémoire, ledit registre étant réglable par l'intermédiaire des bornes extérieures de la matrice de mémoire intégrée et verrouillable par l'intermédiaire d'au moins une borne extérieure supplémentaire (Sv).

# FIG. 1

FIG.2